# EUROPEAN PATENT APPLICATION

(11) **EP 4 755 505 A1**
(43) Date of publication of application: **10.06.2026**
(21) Application number: 24851541.3
(22) Date of filing: 16.07.2024
(51) Int. Cl.: B01J 19/12, G01N 17/00

(54) **LIGHT SOURCE DEVICE AND IRRADIATION DEVICE**

(30) Priority: 04.08.2023 JP 2023127623; 28.03.2024 JP 2024053080
(71) Applicant: Iwasaki Electric Co., Ltd., Tokyo 103-0004 (JP)
(72) Inventor: SATO, Kazuaki, Gyoda City, Saitama 3618505 (JP); SAITO, Seiji, Gyoda City, Saitama 3618505 (JP); YONEYAMA, Naoto, Gyoda City, Saitama 3618505 (JP); SATO, Takashi, Gyoda City, Saitama 3618505 (JP)
(74) Representative: Studio Torta S.p.A.
(86) International application number: PCT/JP2024/025453
(87) International publication number: WO 2025/033112

(57) **Abstract**

A light source apparatus includes a first-light-source unit including one or more types of semiconductor light sources and for emitting a first ultraviolet light, a second-light-source unit including one or more types of semiconductor light sources and for emitting a second ultraviolet light differing in at least one of central wavelength and spectrum from the first ultraviolet light, a light tunnel for guiding each of the first ultraviolet light and the second ultraviolet light, and a mixing optical system provided within the light tunnel and configured to mix the first ultraviolet light and the second ultraviolet light to obtain a third ultraviolet light, wherein an inner surface of the light tunnel is a reflective surface for reflecting the first ultraviolet light, the second ultraviolet light, and the third ultraviolet light, and the third ultraviolet light obtained through mixture by the mixing optical system is emitted by the light tunnel.

## Description

### TECHNICAL FIELD

This disclosure relates to light source apparatuses and to irradiation apparatuses.

### BACKGROUND ART

A light source apparatus is known that includes, as a light source, an ultraviolet discharge lamp such as a high-pressure mercury lamp or a metal halide lamp. Light source apparatuses of this type are widely used for various types of apparatuses such as a light resistance test apparatus configured to test light resistance of an object, a light-curing apparatus configured to cure photocurable resin by use of light, and an ultraviolet light source apparatus provided in a printing machine and configured to cure ultraviolet-curable ink. In addition, currently, in a technical field of light source apparatuses, for the purpose of reduction in environmental impact, etc., discharge lamps containing mercury are being replaced with light-emitting diodes (LEDs). However, the spectrum of an ultraviolet discharge lamp includes a spectrum continuous in a relatively wide range of wavelengths; thus, it may be difficult to replace an ultraviolet discharge lamp with a single type of ultraviolet LED. Consequently, a light source apparatus that can be used for replacement of an ultraviolet discharge lamp needs a configuration in which different types of ultraviolet LEDs that differ in central wavelength are provided to obtain a spectrum continuous in a predetermined range of wavelengths by emission performed by the ultraviolet LEDs that are combined.

Patent Document 1 discloses a technique in which lights from different light sources are mixed by beam splitters. In addition, Patent Document 2 discloses a technique in which lights from different light sources are mixed by dichroic mirrors.

### Related Art Document

### Patent Documents

Patent Document 1: Japanese Patent Application, Laid-Open Publication No. 2021-96998
Patent Document 2: Japanese Patent Application, Laid-Open Publication No. 2010-263218

### SUMMARY OF THE INVENTION

### Problem to be Solved by the Invention

However, in conventional techniques, uniformity of each of illuminance and a spectrum on an irradiation area irradiated with mixed ultraviolet lights is not considered.

An object of this disclosure is to provide a light source apparatus and an irradiation apparatus that can improve uniformity of each of illuminance and a spectrum on an irradiation area.

### Means for Solving Problem

A light source apparatus according to an aspect of this disclosure includes a first light source unit including one or more types of semiconductor light sources and configured to emit a first ultraviolet light, a second light source unit including one or more types of semiconductor light sources and configured to emit a second ultraviolet light differing in central wavelength from the first ultraviolet light, a light tunnel configured to guide each of the first ultraviolet light and the second ultraviolet light, and a mixing optical system provided within the light tunnel and configured to mix the first ultraviolet light and the second ultraviolet light to obtain a third ultraviolet light, wherein an inner surface of the light tunnel is a reflective surface configured to reflect the first ultraviolet light, the second ultraviolet light, and the third ultraviolet light, and the third ultraviolet light obtained through mixture by the mixing optical system is emitted by the light tunnel.

### Effect of Invention

According to an aspect of this disclosure, it is possible to improve uniformity of each of illuminance and a spectrum on an irradiation area.

### BRIEF DESCRIPTION OF THE DRAWINGS

Fig. 1 is a schematic perspective view of an example of a configuration of a light source apparatus according to a first embodiment of this disclosure.
Fig. 2 is a schematic cross section of an example of an internal configuration of the light source apparatus.
Fig. 3 is a diagram showing examples of ultraviolet LEDs included in a first light source unit and a second light source unit individually.
Fig. 4 is a plan view of an example of an LED board included in the second light source unit.
Fig. 5 is a diagram showing locations of measurement points for a spectrum on an irradiation area.
Fig. 6 is a diagram showing measurement results of the spectrum at the individual measurement points shown in Fig. 5.
Fig. 7 is a diagram showing measurement points for illuminance measurement in the irradiation area and illuminance measurement values at the measurement points.
Fig. 8 is a diagram showing states of adaptation of a third ultraviolet light to wavelength range provisions by JIS.
Fig. 9 is a schematic perspective view of an example of a configuration of a light source apparatus according to a second embodiment of this disclosure.
Fig. 10 is a schematic cross section of an example of an internal configuration of the light source apparatus.
Fig. 11 is a diagram showing transmission characteristics and reflection characteristics of a dichroic mirror.
Fig. 12 is a plan view of examples of two LED boards included in the first light source unit.
Fig. 13 is a diagram showing measurement results of a spectrum at individual measurement points in the irradiation area.
Fig. 14 is a diagram showing the measurement points for illuminance measurement in the irradiation area and illuminance measurement values at the measurement points.
Fig. 15 is a diagram showing states of adaptation of the third ultraviolet light to the wavelength range provisions by JIS.
Fig. 16 is a perspective view of an irradiation apparatus according to a third embodiment as viewed from above.
Fig. 17 is a perspective view of an external configuration of the irradiation apparatus as viewed from below.
Fig. 18 is an exploded perspective view of the irradiation apparatus.
Fig. 19 is a longitudinal cross section of a light source apparatus according to the third embodiment.
Fig. 20 is a plan view of the irradiation apparatus as viewed in a direction of the bottom surface.
Fig. 21 is a perspective view of the irradiation apparatus as viewed in a direction of a side of the bottom surface.
Fig. 22 is an assembly diagram for a partition unit and a light tunnel.
Fig. 23 is a perspective view of the irradiation apparatus as viewed in a direction of a side of the upper surface.
Fig. 24 is a plan view of an LED board group.
Fig. 25 is a diagram showing modifications of an arrangement of the LED board group.
Fig. 26 is a diagram showing a modification of the irradiation apparatus according to the third embodiment.
Fig. 27 is a diagram showing another modification of the irradiation apparatus according to the third embodiment.

### MODES FOR CARRYING OUT THE INVENTION

Hereinafter, preferred embodiments according to this disclosure will be described with reference to the drawings. It should be noted that in the drawings, dimensions and scales of elements may differ from those of actual products as appropriate, and some elements may be schematically shown for ease of understanding. Furthermore, the scope of this disclosure is not limited to embodiments stated in the following explanations unless otherwise stated in the following explanation that this disclosure is particularly limited thereto. The scope of this disclosure includes the scope of equivalents of the embodiments.

### 1. First Embodiment

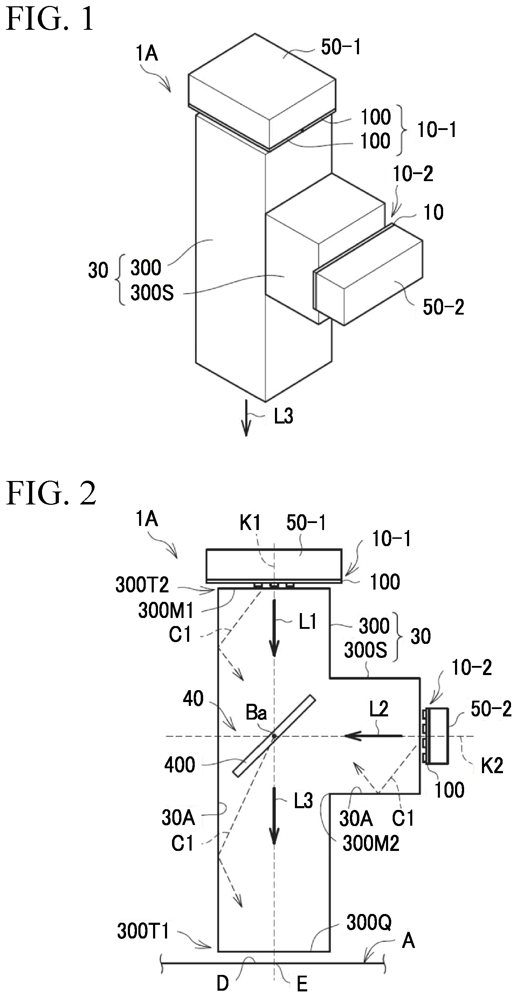

Fig. 1 is a schematic perspective view of an example of a configuration of a light source apparatus 1A according to this embodiment. Fig. 2 is a schematic cross section of an example of an internal configuration of the light source apparatus 1A. The light source apparatus 1A is an apparatus that can be used by being incorporated, as an alternative light source to an ultraviolet discharge lamp, in a variety of types of apparatuses such as a light resistance test apparatus, a light-curing apparatus, and a semiconductor production apparatus. As shown in Fig. 1 and Fig. 2, the light source apparatus 1A according to this embodiment includes a first light source unit 10-1 configured to emit a first ultraviolet light L1, a second light source unit 10-2 configured to emit a second ultraviolet light L2 differing in at least one of central wavelength and spectrum from the first ultraviolet light L1, a light tunnel 30 configured to guide each of the first ultraviolet light L1 and the second ultraviolet light L2, and a mixing optical system 40 provided within the light tunnel 30 and configured to mix the first ultraviolet light L1 and the second ultraviolet light L2, and is configured to emit a third ultraviolet light L3, which is obtained through mixture by the mixing optical system 40, from the light tunnel 30 toward a stage A. On the stage A, an appropriate target to be irradiated with the third ultraviolet light L3 is placed.

The light source apparatus 1A according to this embodiment includes a first cooler unit 50-1 configured to cool the first light source unit 10-1 and a second cooler unit 50-2 configured to cool the second light source unit 10-2. The first cooler unit 50-1 and the second cooler unit 50-2 each include one or more types of appropriate cooling means such as a heat sink, an air-cooling fan, and a water-cooling system, for example. Although not shown, the light source apparatus 1A includes a light source controller configured to control the first light source unit 10-1 and the second light source unit 10-2 to turn on, turn off, or dim, and a cooling controller configured to control operations of the first cooler unit 50-1 and the second cooler unit 50-2.

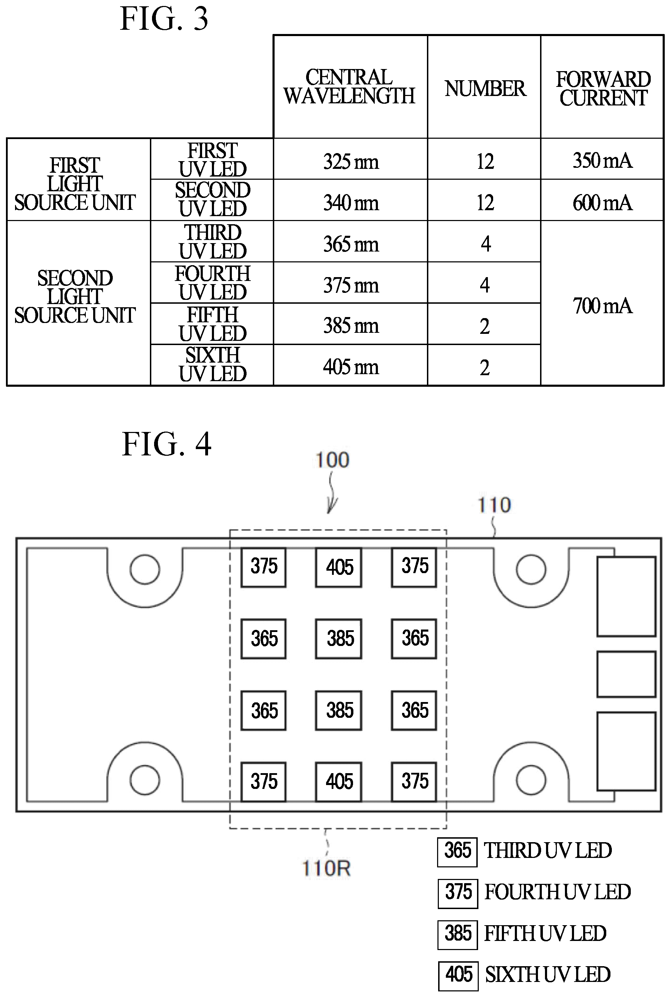

Fig. 3 is a diagram showing examples of ultraviolet LEDs included in the first light source unit 10-1 and the second light source unit 10-2 individually. To approximate to a spectrum of an ultraviolet discharge lamp to be replaced, the first light source unit 10-1 and the second light source unit 10-2 of the light source apparatus 1A each include one or more types of ultraviolet LEDs differing in at least one of central wavelength and spectrum. The ultraviolet LEDs are included in examples of "semiconductor light sources" according to this disclosure. An existing accelerated weathering test apparatus including a metal halide lamp as a light source is an apparatus configured to irradiate an irradiation target with light, which is emitted by the metal halide lamp and passes through a filter. The light source apparatus 1A according to this embodiment realizes a spectrum of the light, which passes through the filter in the existing accelerated weathering test apparatus, by mixing lights differing in peak wavelength emitted by multiple LEDs. Specifically, as shown in Fig. 3, to reproduce the spectrum, the first light source unit 10-1 includes two types of ultraviolet LEDs constituted of first ultraviolet LEDs and second ultraviolet LEDs, and the second light source unit 10-2 includes four types of ultraviolet LEDs constituted of third ultraviolet LEDs, fourth ultraviolet LEDs, fifth ultraviolet LEDs, and sixth ultraviolet LEDs. In this embodiment, a first ultraviolet LED to a sixth ultraviolet LED are LEDs that differ in central wavelength. In other words, as shown in Fig. 3, the respective central wavelengths of the first ultraviolet LED, the second ultraviolet LED, the third ultraviolet LED, the fourth ultraviolet LED, the fifth ultraviolet LED, and the sixth ultraviolet LED are 325 nm, 340 nm, 365 nm, 375 nm, 385 nm, and 405 nm. Ultraviolet lights of six types of ultraviolet LEDs differing in central wavelength are mixed by the mixing optical system 40 to obtain the third ultraviolet light L3; thus, a spectrum of the third ultraviolet light L3 is a spectrum continuous in a relatively wide range of wavelengths. In addition, the number and a forward current of each of the six types of ultraviolet LEDs are determined such that the spectrum of the third ultraviolet light L3 approximates to a spectrum of a light of a metal halide lamp passing through a filter in an existing accelerated weathering test apparatus.

Fig. 4 is a plan view of an example of an LED board 100 provided in the second light source unit 10-2. The LED board 100 includes the above-mentioned four types of ultraviolet LEDs, which are constituted of the third ultraviolet LEDs to the sixth ultraviolet LEDs provided in the second light source unit 10-2, and a mounting board 110 provided with these ultraviolet LEDs. The mounting board 110 is a printed circuit board that is substantially rectangular in plan view. Each of the ultraviolet LEDs is provided within a central area 110R located substantially in the center of the mounting board 110. Within this central area 110R, the respective ultraviolet LEDs are arranged to be widely dispersed for each type such that ultraviolet LEDs of the same type are symmetric with respect to the center of the central area.

As shown in Fig. 1 described above, the first light source unit 10-1 includes two LED boards 100. One LED board 100 of the two includes a central area 110R in which the first ultraviolet LEDs are provided, and the other LED board 100 includes a central area 110R in which the second ultraviolet LEDs are provided.

In this embodiment, a central area 110R has a shape of a square with a side of approximately 25 mm, and ultraviolet lights of one or more types of ultraviolet LEDs are emitted from substantially an entire surface of the central area 110R. Furthermore, in this embodiment, the first ultraviolet LED to the sixth ultraviolet LED are each a packaged LED, which is a light source not provided with any of optical elements such as a lens. Each of the ultraviolet LEDs emits an ultraviolet light at a relatively wide radiation angle (for example, 120 degrees); as a result, a radiation angle of an ultraviolet light emitted from an LED board 100 is relatively wide. The radiation angle is assumed to be an appropriate angle of 15 degrees or more and 180 degrees or less. It should be noted that some or all of the one or more types of LEDs provided in the first light source unit 10-1 and the second light source unit 10-2 individually may include an optical element, or may include a surface mount device (SMD) LED, a chip on board (COB) LED, or a through-hole LED.

Returning to Fig. 2 described above, the mixing optical system 40 according to this embodiment includes a beam splitter 400. The beam splitter 400 according to this embodiment is a plate-type optical element. The beam splitter 400 has optical properties with 70% transmittance and 30% reflectance in a case in which an incident light has an incidence angle of 45 degrees. The beam splitter 400 is provided at an intersection point Ba, at which a first optical axis K1 of the first ultraviolet light L1 and a second optical axis K2 of the second ultraviolet light L2 intersect, and is in an orientation inclined at 45 degrees relative to each of the first optical axis K1 and the second optical axis K2. This beam splitter 400 mixes light components of the first ultraviolet light L1 passing through the beam splitter 400 and light components of the second ultraviolet light L2 reflected by the beam splitter 400 to obtain the third ultraviolet light L3.

As shown in Fig. 2, the light tunnel 30 comprises a hollow conduit 300 extending linearly, an end portion 300T1 of the conduit 300 being provided with an opening that is an outlet 300Q configured to emit the third ultraviolet light L3. An opposite end portion 300T2 of the conduit 300 is provided with an opening that is a first inlet 300M1 configured to let in a light among the first ultraviolet light L1 and the second ultraviolet light L2. A side surface of the conduit 300 is provided with an opening that is a second inlet 300M2 configured to let in the other light among the first ultraviolet light L1 and the second ultraviolet light L2.

In this embodiment, the first light source unit 10-1 is provided at the first inlet 300M1, and the first ultraviolet light L1 enters through the first inlet 300M1. On the other hand, the second light source unit 10-2 is provided in a secondary conduit 300S extending from the second inlet 300M2, and the second ultraviolet light L2 enters through the second inlet 300M2. In this configuration, the first light source unit 10-1 is provided such that the first optical axis K1 of the first ultraviolet light L1 substantially coincides with a central axis of the conduit 300. The second light source unit 10-2 is provided such that the second optical axis K2 of the second ultraviolet light L2 is perpendicular to the central axis of the conduit 300. In addition, as described above, within the conduit 300, the beam splitter 400 is provided at the intersection point Ba at which the first optical axis K1 and the second optical axis K2 intersect, and the third ultraviolet light L3 travels from the beam splitter 400 toward the outlet 300Q.

In this embodiment, to substantially equalize a distance from the intersection point Ba to the first inlet 300M1 and a distance from the intersection point Ba to the second inlet 300M2, the second inlet 300M2 is provided with the secondary conduit 300S extending from the side surface of the conduit 300 in a direction perpendicular to the central axis of the conduit 300. An end portion of this secondary conduit 300S is provided with the second light source unit 10-2. A cross-sectional shape and cross-sectional dimensions of the secondary conduit 300S are substantially the same as those of the conduit 300.

In this embodiment, a cross-sectional shape of each of the conduit 300 and the secondary conduit 300S and a shape of an opening of each of the first inlet 300M1, the second inlet 300M2, and the outlet 300Q are each square. Each of the conduit 300 and the secondary conduit 300S has a side of approximately 50 mm in inner dimension, and a distance from the first inlet 300M1 to the outlet 300Q is 160.5 mm. In addition, a distance from the intersection point Ba to the first inlet 300M1 is 65.5 mm, and a distance from the intersection point Ba to a portion of the secondary conduit 300S provided with the second light source unit 10-2 is also 65.5 mm. The outlet 300Q has a shape of a square with a side of 50 mm as with the inner dimension of the conduit 300, and an irradiation area D, which has a center E included in the first optical axis K1 and has predetermined dimensions and a predetermined shape, is set in a location 5 mm away from the outlet 300Q. In this embodiment, the irradiation area D is set as a region having a shape of a square with a side of 25 mm.

It should be noted that shapes and dimensions of the conduit 300 and the secondary conduit 300S, and shapes and dimensions of the first inlet 300M1, the second inlet 300M2, and the outlet 300Q are appropriately set in accordance with a desired shape, dimensions, illuminance, etc., of the irradiation area D, for example.

In the light tunnel 30 according to this embodiment, the conduit 300 and the secondary conduit 300S are each formed using a plate mainly made of material with high reflectance such as aluminum, and an inner surface 30A of the light tunnel 30 is a reflective surface configured to reflect ultraviolet light with high reflectance. On the other hand, as described above, the first light source unit 10-1 and the second light source unit 10-2 emit the first ultraviolet light L1 and the second ultraviolet light L2, respectively, at a relatively wide radiation angle (for example, 120 degrees or more). Thus, as shown by dashed arrows C1 in Fig. 2, within the light tunnel 30, the first ultraviolet light L1, the second ultraviolet light L2, and the third ultraviolet light L3 each travel while being repeatedly reflected by the inner surface 30A. As a result, the third ultraviolet light L3 is an ultraviolet light in which the respective ultraviolet lights of the six types of ultraviolet LEDs provided in the first light source unit 10-1 and second light source unit 10-2 are sufficiently mixed. The third ultraviolet light L3 is emitted to the irradiation area D; thus, it is possible to improve uniformity of illuminance and a spectrum on the irradiation area D. It should be noted that the dashed arrows C1 shown in Fig. 2 are objects conceptually showing states of reflection, but are not objects showing paths of rays of light.

Next, measurement results of illuminance and a spectrum on the irradiation area D will be described.

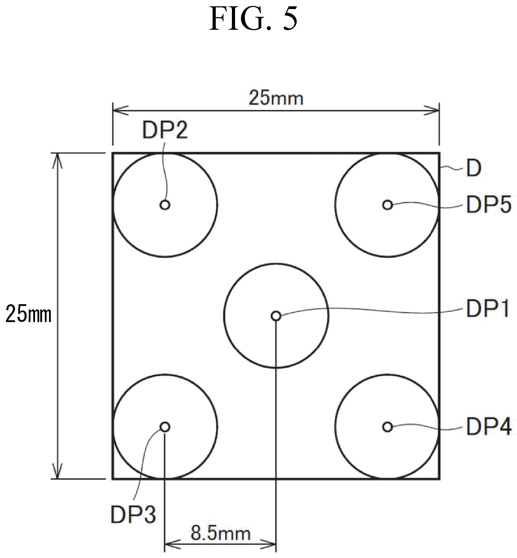

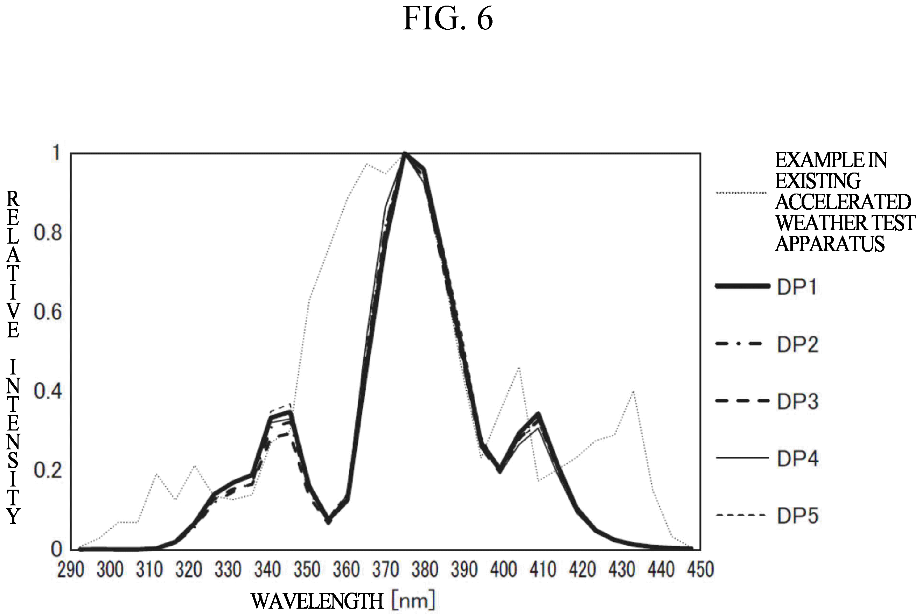

Fig. 5 is a diagram showing locations of measurement points for the spectrum on the irradiation area D. Fig. 6 is a diagram showing measurement results of the spectrum at the individual measurement points shown in Fig. 5. As described above, the irradiation area D according to this embodiment has a shape of a square with a side of 25 mm, and as shown in Fig. 5, in this irradiation area D, measurement points from a first measurement point DP1 to a fifth measurement point DP5 are set. The first measurement point DP1, the second measurement point DP2, the third measurement point DP3, the fourth measurement point DP4, and the fifth measurement point DP5 correspond to a center, a vicinity of an upper left corner, a vicinity of a lower left corner, a vicinity of a lower right corner, and a vicinity of an upper right corner of the irradiation area D, respectively. It should be noted that in Fig. 5, a circle surrounding each of the measurement points indicates a light receiving range of a spectrum sensor.

As shown in Fig. 6, relative intensities of spectra measured at the first measurement point DP1 to the fifth measurement point DP5 are substantially the same. Thus, it can be understood that the spectrum is uniform in the irradiation area D.

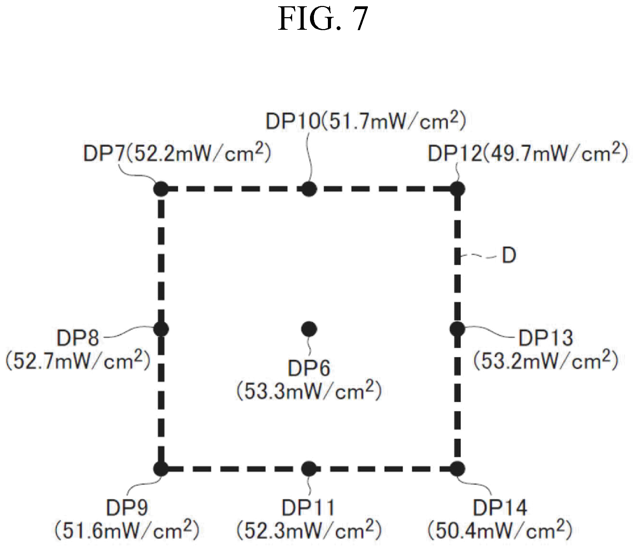

Fig. 7 is a diagram showing measurement points for illuminance measurement in the irradiation area D and illuminance measurement values at the measurement points. As shown in the drawing, in the irradiation area D, a sixth measurement point DP6 to a fourteenth measurement point DP14 are set as the measurement points for illuminance measurement. The sixth measurement point DP6 to the fourteenth measurement point DP14 correspond to a center, an upper left corner, a middle of a left side, a lower left corner, a middle of an upper side, a middle of a lower side, an upper right corner, a middle of a right side, and a lower right corner of the irradiation area D, respectively. From the illuminance measurement values at the individual points from the sixth measurement point DP6 to the fourteenth measurement point DP14, a uniformity ratio of illumination of the irradiation area D that is 90% or more is calculated. When the illuminance measurement values shown in Fig. 7 are used for a formula (uniformity ratio of illumination = MIN value / MAX value × 100), the uniformity ratio of illumination is approximately 93%; thus, it can be understood that uniformity of the illuminance is high.

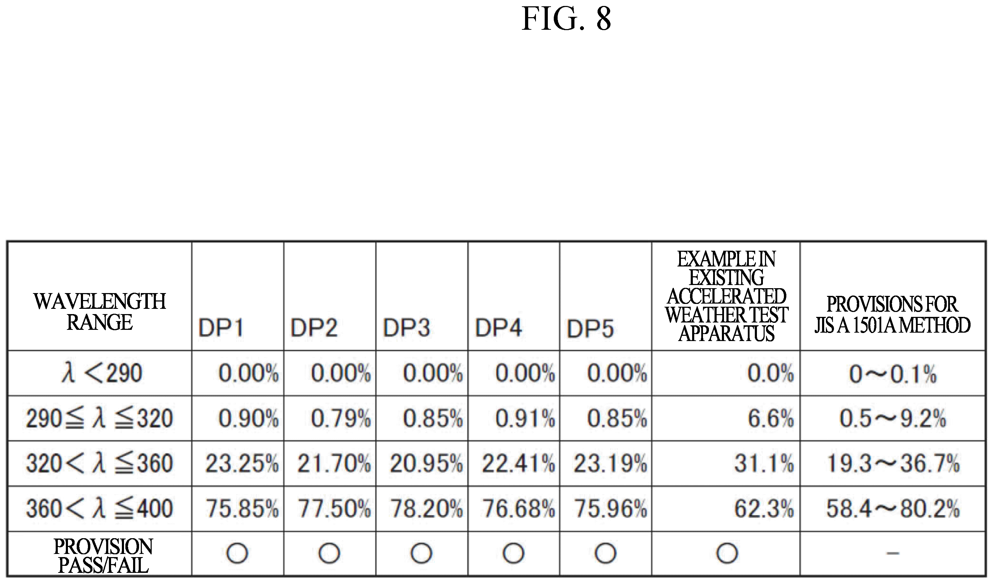

Fig. 8 is a diagram showing states of adaptation of the third ultraviolet light L3 to wavelength range provisions by Japanese Industrial Standards (JIS). It should be noted that such wavelength range provisions are provisions for JIS A 1501A method "accelerated weathering test method for unplasticized polyvinyl chloride windows and doors by metal halide lamp." As shown in the drawing, any point among the first measurement point DP1 to the fifth measurement point DP5 conforming to the wavelength range provisions by JIS is shown.

As described above, the light source apparatus 1A according to this embodiment includes the first light source unit 10-1 including the two types of ultraviolet LEDs and configured to emit the first ultraviolet light L1, the second light source unit 10-2 including the four types of ultraviolet LEDs and configured to emit the second ultraviolet light L2 differing in at least one of a central wavelength and spectrum from the first ultraviolet light L1, the light tunnel 30 configured to guide each of the first ultraviolet light L1 and the second ultraviolet light L2, and the mixing optical system 40 provided within the light tunnel 30 and configured to mix the first ultraviolet light L1 and the second ultraviolet light L2 to obtain the third ultraviolet light. The inner surface 30A of the light tunnel 30 is a reflective surface configured to reflect the first ultraviolet light L1, the second ultraviolet light L2, and the third ultraviolet light L3, and the third ultraviolet light L3 obtained through mixture by the mixing optical system 40 is emitted by the light tunnel 30.

According to this configuration, since the third ultraviolet light L3 is obtained by mixing the ultraviolet lights of the six types of ultraviolet LEDs in total, the spectrum of the third ultraviolet light L3 becomes a continuous spectrum as in an ultraviolet discharge lamp and has optical properties for an alternative light source to the ultraviolet discharge lamp. In particular, the light source apparatus 1A contains no mercury, in contrast to a mercury-discharge lamp, thereby contributing to reduction in environmental impact. In addition, the light source apparatus 1A includes, as light sources, the semiconductor light sources such as ultraviolet LEDs, thereby having a relatively long service life compared to a discharge lamp; thus, it is possible to reduce frequency of maintenance work such as replacement work for a discharge lamp. Furthermore, the light sources are divided into two that are a first light source unit 10-1 and a second light source unit 10-2; thus, even when the numbers of ultraviolet LEDs to be provided increases depending on a request for illuminance, it is possible to ensure an area in which the ultraviolet LEDs are provided for each of the light source units, and it is possible to prevent an increase in size of an apparatus. In addition, since the light sources are divided into the first light source unit 10-1 and the second light source unit 10-2, it is possible to reduce a cooling capacity required for a cooler unit (the first cooler unit 50-1, the second cooler unit 50-2) for cooling a single light source unit and it is possible to substantially prevent an increase in size of a cooler unit and to cut costs. In addition to this, since the first ultraviolet light L1, the second ultraviolet light L2, and the third ultraviolet light L3 are mixed due to reflection by the inner surface 30A of the light tunnel 30, it is possible to improve uniformity of illuminance of a spectrum on the irradiation area D.

In the light source apparatus 1A according to this embodiment, the first light source unit 10-1 and the second light source unit 10-2 emit the first ultraviolet light L1 and the second ultraviolet light L2, respectively, at a radiation angle at which multiple reflections occur on the inner surface 30A of the light tunnel 30.

According to this configuration, since multiple reflections of each of the first ultraviolet light L1, the second ultraviolet light L2, and the third ultraviolet light L3 by the inner surface 30A of the light tunnel 30 are induced, it is possible to further improve uniformity of illuminance and a spectrum on the irradiation area D.

### 2. Second Embodiment

In the first embodiment, a light source apparatus 1A is described in which the mixing optical system 40 includes the beam splitter 400. In this embodiment, a light source apparatus 1B will be described in which the mixing optical system 40 includes a dichroic mirror 410. It should be noted that in the description of a second embodiment, elements described in the first embodiment will be denoted by the same reference signs used in the description of the embodiment described above, and detailed description thereof will be omitted.

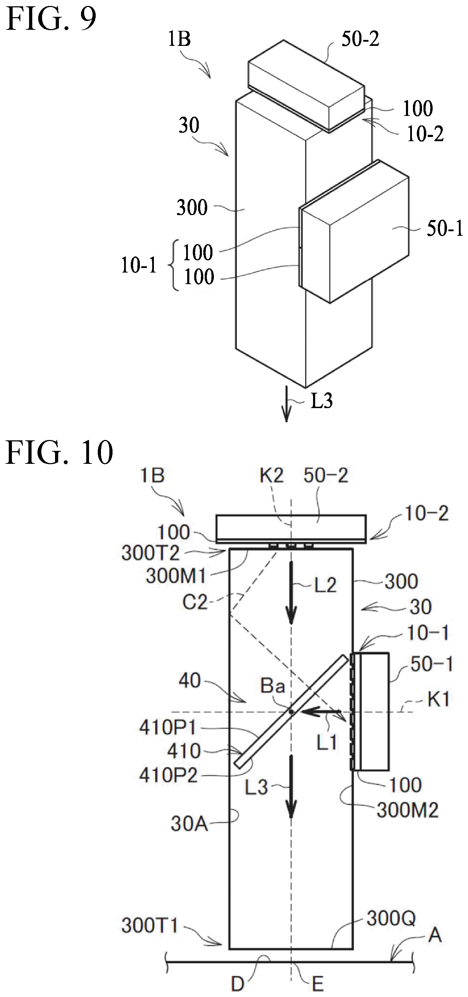

Fig. 9 is a schematic perspective view of an example of a configuration of the light source apparatus 1B according to this embodiment. Fig. 10 is a schematic cross section of an example of an internal configuration of the light source apparatus 1B. As shown in Fig. 9 and Fig. 10, in the light source apparatus 1B, the dichroic mirror 410 that is an example of the mixing optical system 40 is provided within the light tunnel 30. Similarly to the beam splitter 400 according to the first embodiment, the dichroic mirror 410 is provided at the intersection point Ba, at which the first optical axis K1 of the first ultraviolet light L1 and the second optical axis K2 of the second ultraviolet light L2 intersect, and it is in an orientation inclined at 45 degrees relative to each of the first optical axis K1 and the second optical axis K2.

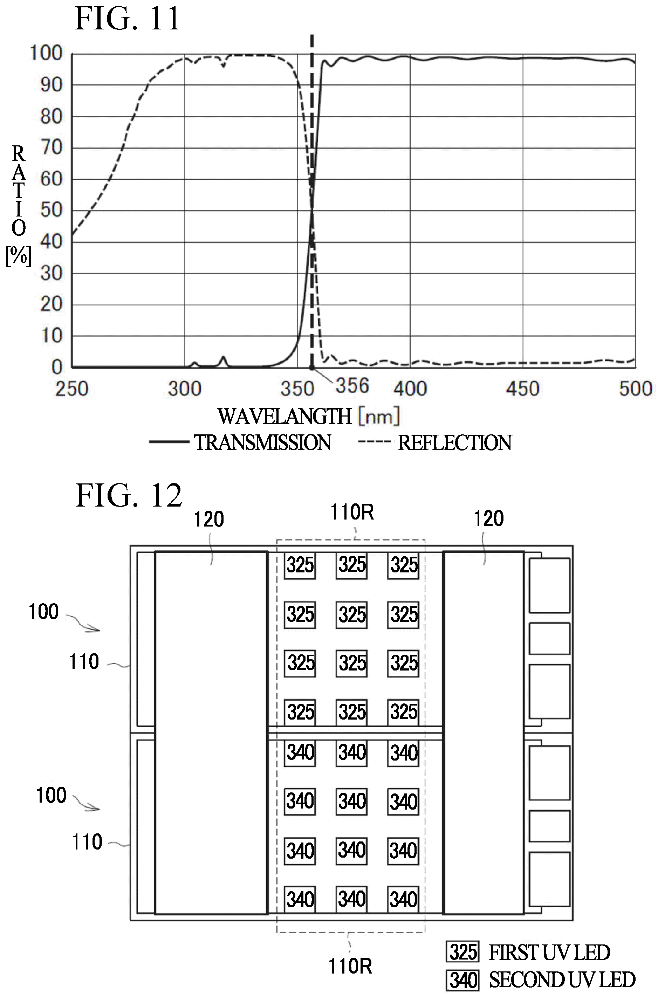

Fig. 11 is a diagram showing transmission characteristics and reflection characteristics of the dichroic mirror 410. As shown in Fig. 11, the dichroic mirror 410 has a designed incidence angle of 45 degrees for each of transmission and reflection and has characteristics by which ultraviolet lights within a wavelength band of approximately 356 nm or less are reflected and ultraviolet lights within a wavelength band of approximately 356 nm or more pass through. On the other hand, as shown in Fig. 3 described above, the first light source unit 10-1 is provided with the ultraviolet LEDs each having a central wavelength of 340 nm or less; thus, the first light source unit 10-1 is optimally configured as a light source for using reflection by the dichroic mirror 410. In addition, the second light source unit 10-2 is provided with the ultraviolet LEDs each having a central wavelength of 365 nm or more; thus, the second light source unit 10-2 is optimally configured as a light source for using transmission by the dichroic mirror 410.

Thus, among a first surface 410P1 and a second surface 410P2 provided in the dichroic mirror 410, to the first surface 410P1 for light that is to pass through, the second ultraviolet light L2 of the second light source unit 10-2 travels, and to the second surface 410P2 for light that is to be reflected, the first ultraviolet light L1 of the first light source unit 10-1 travels; as a result, it is possible to substantially prevent loss due to the dichroic mirror 410 and to efficiently obtain the third ultraviolet light L3.

Here, in this embodiment, the second inlet 300M2 formed in the side surface of the light tunnel 30 is provided not with the second light source unit 10-2, but with the first light source unit 10-1 configured to emit the first ultraviolet light L1 having wavelengths shorter than those of the second ultraviolet light L2 of the second light source unit 10-2. In other words, the dichroic mirror 410 is provided to be in an orientation in which the second surface 410P2 faces the side surface of the light tunnel 30 and further faces the outlet 300Q. Furthermore, in the light tunnel 30 according to this embodiment, the secondary conduit 300S is not provided at the second inlet 300M2, and the first light source unit 10-1 is directly provided at the second inlet 300M2. Thus, a distance from the first light source unit 10-1 to the outlet 300Q (the irradiation area D) is shorter than a distance from the second light source unit 10-2 to the outlet 300Q (the irradiation area D).

Generally, in a semiconductor light source such as an LED, luminance efficiency reduces with a reduction in wavelength of light to be emitted; thus, a large amount of power is consumed to obtain a certain amount of light. In contrast to this, according to this light source apparatus 1B, since the first light source unit 10-1 with shorter wavelengths is disposed closer to the irradiation area D than the second light source unit 10-2, a desired amount of first ultraviolet light L1 can be obtained with less power; thus, it is possible to realize the light source apparatus 1B with high efficiency.

Fig. 12 a plan view of examples of two LED boards 100 included in the first light source unit 10-1. As described above, each of the two LED boards 100 includes the central area 110R, and the plurality of first ultraviolet LEDs is arranged in one of the central areas 110R, and the plurality of second ultraviolet LEDs is arranged in the other of the central areas 110R. In addition, as shown in Fig. 12, both sides of the LED boards 100 according to this embodiment across the central areas 110R are provided with reflective plates 120 configured to reflect the second ultraviolet light L2 emitted by the second light source unit 10-2 and the first ultraviolet light L1 emitted by the first light source unit 10-1. The reflective plates 120 are examples of "reflectors" according to this disclosure and are, for example, metal plates made of aluminum, etc. The dichroic mirror 410 has a relatively high transmittance; thus, as shown by a dashed arrow C2 in Fig. 10, a part of the second ultraviolet light L2 passing through the dichroic mirror 410 reaches the LED boards 100 of the first light source unit 10-1. Then, this second ultraviolet light L2 is reflected by the reflective plates 120 so as to be emitted as the third ultraviolet light L3 from the outlet 300Q; thus, it is possible to substantially prevent loss of the second ultraviolet light L2. Furthermore, the first ultraviolet light L1 is added; thus, it is possible to further improve effectiveness of the light source apparatus 1B.

In addition, since the secondary conduit 300S is not provided, when a part of the second ultraviolet light L2 passing through the dichroic mirror 410 reaches the second inlet 300M2 at which the first light source unit 10-1 is provided, the second ultraviolet light L2 is reflected by the reflective plates 120 provided in the second inlet 300M2 without entering the secondary conduit 300S. In this way, it is possible to prevent reduction in uniformity ratio of illumination of the irradiation area D caused by a part of the second ultraviolet light L2 entering the secondary conduit 300S or being absorbed by the LED boards 100 of the first light source unit 10-1, etc., and it is possible to maintain the uniformity of illuminance. It should be noted that the effects described above are provided by a resist with a higher ultraviolet reflectance provided in the LED boards 100 in place of the provided reflective plates 120. In addition, although not shown in Fig. 4, a second light source unit 10-2 may be provided with a reflector such as a reflective plate 120.

Next, measurement results of illuminance of the irradiation area D and of a spectrum will be described. It should be noted that, in the following measurements, forward currents of the third ultraviolet LEDs to the sixth ultraviolet LEDs provided in the second light source unit 10-2 are reduced to be half of those of the first embodiment (more exactly, 350 mA).

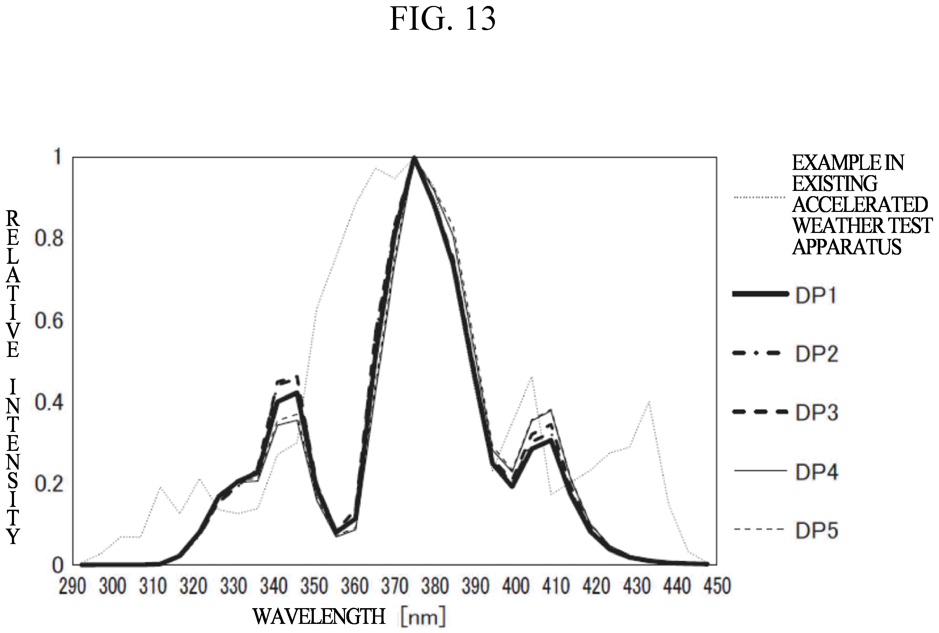

Fig. 13 is a diagram showing measurement results of the spectrum at the individual measurement points in the irradiation area D. It should be noted that a location of each of the measurement points is the same as that in the first embodiment. As shown in the drawing, with respect to the light source apparatus 1B according to this embodiment as in the light source apparatus 1A according to the first embodiment, relative intensities of the spectra measured at the first measurement point DP1 to the fifth measurement point DP5 are substantially the same. Thus, it can be understood that the spectrum is uniform in the irradiation area D.

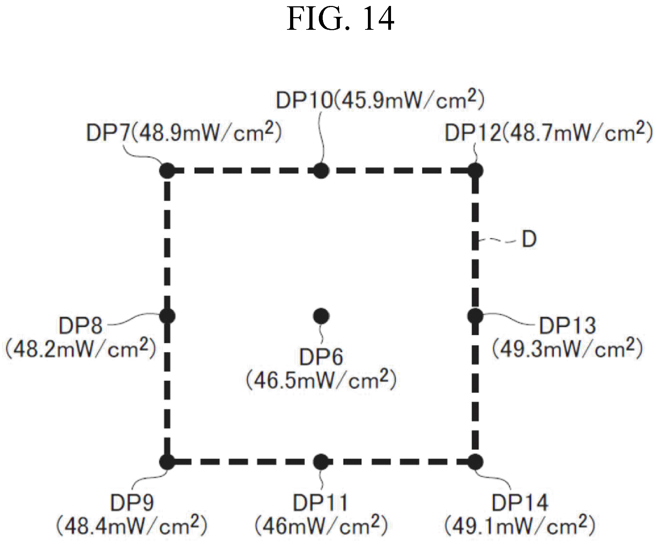

Fig. 14 is a diagram showing measurement points for illuminance measurement in the irradiation area D and illuminance measurement values at the measurement points. As in the light source apparatus 1A according to the first embodiment, with respect to the light source apparatus 1B according to this embodiment from the illuminance measurement values at the individual points from the sixth measurement point DP6 to the fourteenth measurement point DP14, a uniformity ratio of illumination of the irradiation area D that is 90% or more is calculated. When the illuminance measurement values shown in Fig. 14 are used for a formula (uniformity ratio of illumination = MIN value / MAX value × 100), the uniformity ratio of illumination is approximately 93%; thus, it can be understood that uniformity of the illuminance is high. In addition to this, in a state in which the forward currents of the third ultraviolet LEDs to the sixth ultraviolet LEDs provided in the second light source unit 10-2 are less than those of first embodiment, the illuminance measurement values that are substantially the same as those in the first embodiment are obtained at each point of the sixth measurement point DP6 to the fourteenth measurement point DP14; thus, it can be understood that high efficiency is realized.

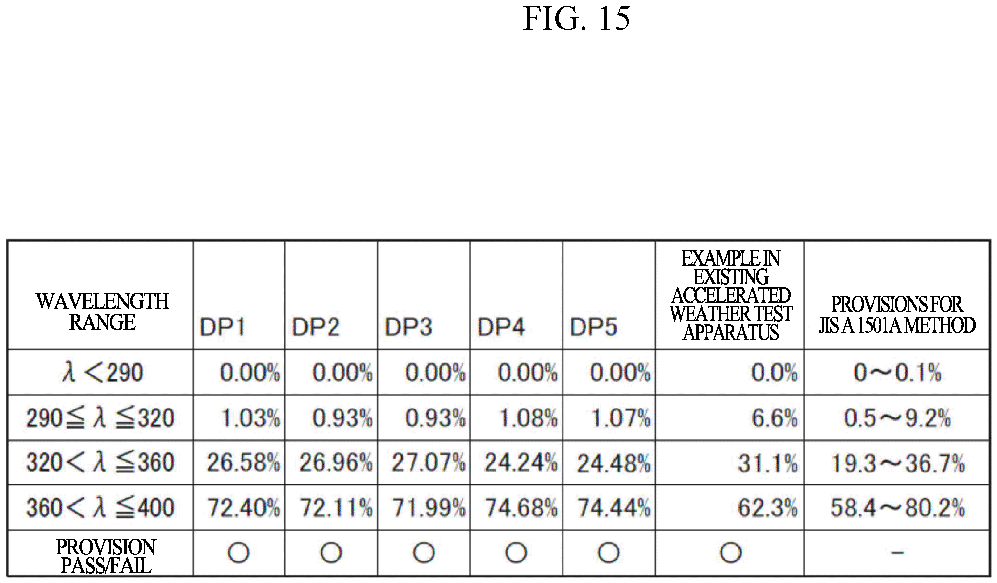

Fig. 15 is a diagram showing states of adaptation of the third ultraviolet light to the wavelength range provisions by JIS. It should be noted that, as in the first embodiment, such wavelength range provisions are provisions for the JIS A 1501A method for "accelerated weathering test method for unplasticized polyvinyl chloride windows and doors by metal halide lamp." As shown in the drawing, in this embodiment as in the first embodiment, any point among the first measurement point DP1 to the fifth measurement point DP5 conforming to the wavelength range provisions by JIS is shown.

In addition, the inventors took measurements for a configuration obtained by shortening an overall length of the conduit 300 (i.e., a distance from the first inlet 300M1 to the outlet 300Q) in the configuration of the light source apparatus 1B. It should be noted that in this example, a distance from the intersection point Ba (the second inlet 300M2) to the outlet 300Q is also shortened. From results of these measurements, knowledge was obtained in which uniformity of a spectrum on the irradiation area D and states of adaptation to the wavelength range provisions by JIS are not affected by shortening the overall length of the conduit 300 in any of the cases including a case in which the overall length of the conduit 300 is 140.5 mm (a distance between the intersection point Ba and the outlet 300Q is 75 mm), a case in which the overall length of the conduit 300 is 120.5 mm (the distance between the intersection point Ba and the outlet 300Q is 55 mm), a case in which the overall length of the conduit 300 is 100.5 mm (the distance between the intersection point Ba and the outlet 300Q is 35 mm), and a case in which the overall length of the conduit 300 is 51 mm (the distance between the intersection point Ba and the outlet 300Q is 25 mm).

On the other hand, when the overall length was shortened, uniformity of illuminance was affected by a difference in locations of the first light source unit 10-1 and the second light source unit 10-2 as viewed from the irradiation area D and by an increase in direct light components reaching the irradiation area D without being reflected by the inner surface 30A of the light tunnel 30; however, it was found that a uniformity ratio of illumination of 90% or more was obtained at any of the overall lengths.

As described above, the light source apparatus 1B according to this embodiment provides the same effects as those provided by the light source apparatus 1A according to the first embodiment.

In addition to this, in the light source apparatus 1B according to this embodiment, among the first light source unit 10-1 and the second light source unit 10-2, a light source unit configured to emit an ultraviolet light with a shorter wavelength (i.e., the first light source unit 10-1) is provided at the second inlet 300M2.

According to this configuration, since the first light source unit 10-1 with a shorter wavelength is provided closer to the irradiation area D than the second light source unit 10-2, a desired amount of first ultraviolet light L1 can be obtained with less power; thus, it is possible to realize the light source apparatus 1B with high efficiency.

In the light source apparatus 1B according to this embodiment, among the first light source unit 10-1 and the second light source unit 10-2, the light source unit provided at the second inlet 300M2 (i.e., the first light source unit 10-1) includes the reflective plates 120 configured to reflect the ultraviolet light emitted by the other light source unit (i.e., the second light source unit 10-2).

According to this configuration, it is possible to prevent reduction in uniformity ratio of illumination of the irradiation area D, and it is possible to maintain the uniformity of the illuminance. Furthermore, it is possible to increase the illuminance of the irradiation area D; thus, it is possible to realize the light source apparatus 1B with higher efficiency.

In the light source apparatus 1B according to this embodiment, the mixing optical system 40 includes the dichroic mirror 410.

According to this configuration, even when the mixing optical system 40 includes the dichroic mirror 410 having a relatively high transmittance, it is possible to maintain the uniformity of the illuminance and to obtain the light source apparatus 1B substantially preventing reduction in effectiveness of the light source apparatus 1B.

### 3. Third Embodiment

In this embodiment, an irradiation apparatus 1000 will be described. The irradiation apparatus 1000 includes components of a plurality of light source apparatuses 1A according to the first embodiment or of a plurality of light source apparatuses 1B according to the second embodiment, and achieves the same uniformity of illuminance and spectrum as that of each of the light source apparatus 1A and the light source apparatus 1B while extending an area of the irradiation area D compared to a single unit of the light source apparatus 1A or of the light source apparatus 1B.

Hereinafter, this irradiation apparatus 1000 will be described in detail. It should be noted that in this embodiment, the irradiation apparatus 1000 that includes components of the plurality of light source apparatuses 1B according to the second embodiment will be described. In addition, in the description of this embodiment, elements described in the first embodiment or the second embodiment will be denoted by the same reference signs used in the description of the embodiment described above, and detailed description thereof will be omitted.

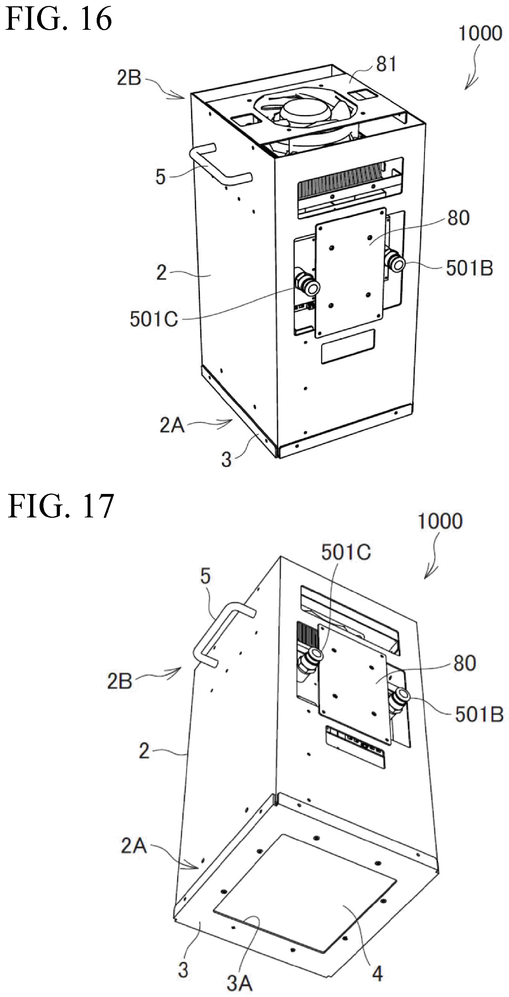

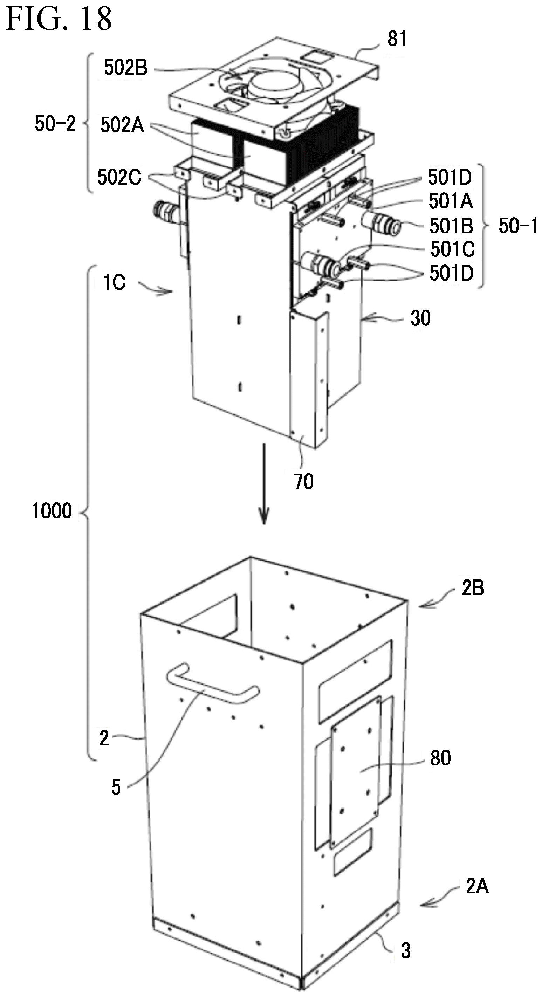

Fig. 16 is a perspective view of the irradiation apparatus 1000 according to this embodiment as viewed from above. Fig. 17 is a perspective view of an external configuration of the irradiation apparatus 1000 as viewed from below. In addition. Fig. 18 is an exploded perspective view of the irradiation apparatus 1000. As shown in Fig. 16 and Fig. 17, the irradiation apparatus 1000 includes a conduit-shaped outer housing 2, and as shown in Fig. 18, a light source apparatus 1C is provided within the outer housing 2. In this embodiment, a cross-sectional shape of the outer housing 2 is square, but it may be a different shape. As the outer housing 2, a plate made of an alloy with high rigidity is used, for example. As shown in Fig. 17, a bottom portion 2A of the outer housing 2 is provided with a bottom plate 3, and the bottom plate 3 includes an opening that is an outlet opening 3A configured to emit third ultraviolet lights L3. As shown in Fig. 16, an upper portion 2B of the outer housing 2 is an open end, and air and wires of LED boards can be moved between the inner side and the outside of the outer housing 2. In addition, a side surface of the outer housing 2 is provided with grips 5 for being held by an operator during transportation, etc.

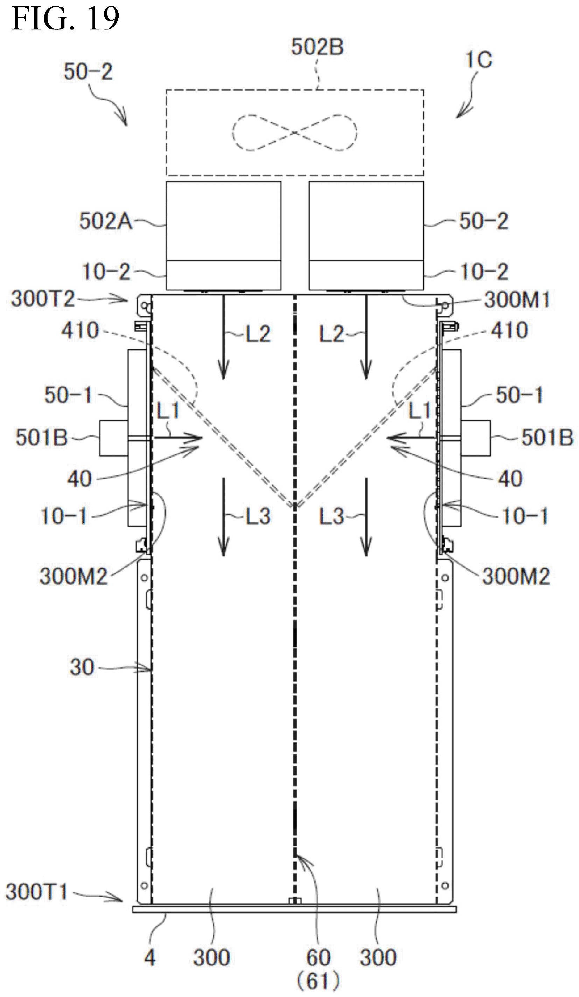

Fig. 19 is a longitudinal cross section of the light source apparatus 1C according to this embodiment. As shown in Fig. 19, similar to the light source apparatus 1A according to the first embodiment and the light source apparatus 1B according to the second embodiment, the light source apparatus 1C includes first light source units 10-1 configured to emit first ultraviolet lights L1, second light source units 10-2 configured to emit second ultraviolet lights L2 differing in at least one of central wavelength and spectrum from the first ultraviolet lights L1, a light tunnel 30 configured to guide each of the first ultraviolet lights L1 and the second ultraviolet lights L2, and mixing optical systems 40 provided within the light tunnel 30 and configured to mix the first ultraviolet lights L1 and the second ultraviolet lights L2, and is configured to emit, from the light tunnel 30, the third ultraviolet lights L3 obtained through mixture by the mixing optical systems 40.

In addition, similar to the light source apparatus 1B according to the second embodiment, the light source apparatus 1C according to this embodiment includes dichroic mirrors 410 as examples of the mixing optical systems 40. In addition, similar to the light source apparatus 1B according to the second embodiment, in the light source apparatus 1C, second inlets 300M2 provided in side surfaces of the light tunnel 30 are provided with the first light source units 10-1, and a first inlet 300M1 provided at an end portion 300T2 of the light tunnel 30 is provided with the second light source units 10-2. The other end portion 300T1 of the light tunnel 30 is provided with a window 4, and the window 4 is made of quartz glass, etc., which transmits at least the third ultraviolet lights L3, for example.

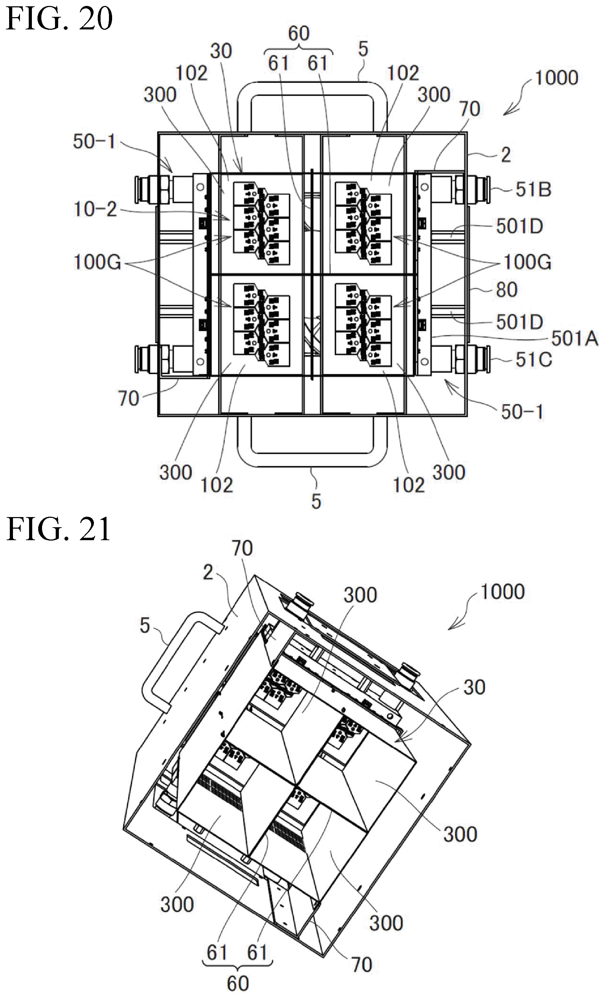

Fig. 20 is a plan view of the irradiation apparatus 1000 as viewed in a direction of the bottom surface, and Fig. 21 is a perspective view of the irradiation apparatus 1000 as viewed in a direction of a side of the bottom surface. It should be noted that in Fig. 20 and Fig. 21, the bottom plate 3 of the irradiation apparatus 1000 and the window 4 of the light source apparatus 1C are omitted. As shown in Fig. 20 and Fig. 21, an interior of the light tunnel 30 of the light source apparatus 1C is divided into a plurality of (in this embodiment, four) conduits 300 by a partition unit 60 constituted of a plurality of reflective plates 61. Each of the plurality of conduits 300 according to this embodiment has the same configuration as that of the conduit 300 in each of the first embodiment and the second embodiment. In other words, each of the plurality of conduits 300 has a shape of a conduit having a constant cross-sectional area and a constant cross-sectional shape in an axial direction, and the cross-sectional shape is square. It should be noted that the cross-sectional shape of a conduit 300 is not limited to a square shape. In addition, cross-sectional areas of the plurality of conduits 300 provided in the light tunnel 30 are the same; however, the cross-sectional areas may differ, or cross-sectional shapes of the plurality of conduits 300 may differ.

As shown in Fig. 19 described above, each of the plurality of conduits 300 in the irradiation apparatus 1000 lets in a second ultraviolet light L2 from one of the second light source units 10-2 provided at the first inlet 300M1. In addition, the irradiation apparatus 1000 includes, for each of the plurality of conduits 300, a first light source unit 10-1 and a dichroic mirror 410. The side surface of the light tunnel 30 is provided with an opening that is a second inlet 300M2 for each of the plurality of conduits 300. The second inlet 300M2 for each of the plurality of conduits 300 is provided with the first light source unit 10-1. The second inlet 300M2 for each of the plurality of conduits 300 lets in a first ultraviolet light L1 of the first light source unit 10-1. In an interior of each of the plurality of conduits 300, the first ultraviolet light L1 is repeatedly reflected to pass through the dichroic mirror 410 and is mixed with the second ultraviolet light L2. A third ultraviolet light L3 obtained by the mixture, the first ultraviolet light L1, and the second ultraviolet light L2 reach the end portion 300T1 while being reflected repeatedly and are emitted to the outside. Thus, in individual areas irradiated with the third ultraviolet light L3 from each of the plurality of conduits 300, illuminance and spectrum distribution are uniform. In addition, these areas are adjacent to one another to form an irradiation area D for the irradiation apparatus 1000; thus, it is possible to extend an area of the irradiation area D and to maintain uniformity of illuminance and spectrum distribution.

In addition to this, since the interior of the light tunnel 30 is divided into the plurality of conduits 300, a cross-sectional area of each of the plurality of conduits 300 is reduced, and the number of multiple reflections of each of the first ultraviolet light L1, the second ultraviolet light L2, and the third ultraviolet light L3 in the interior of each of the plurality of conduits 300 increases. Thus, it is possible to reduce an overall length of the light tunnel 30 while maintaining uniformity of illuminance and spectrum distribution on the irradiation area D.

Next, details of the irradiation apparatus 1000 will now be described. As described above, the light source apparatus 1C includes, in the interior of the light tunnel 30, the partition unit 60 dividing the interior of the light tunnel 30 into the plurality of conduits 300. In this embodiment, to fix parts of the partition unit 60 to each other and to fix the partition unit 60 to the light tunnel 30, interlocking structures for fixing members to each other are used rather than fastening members such as screws or bolts.

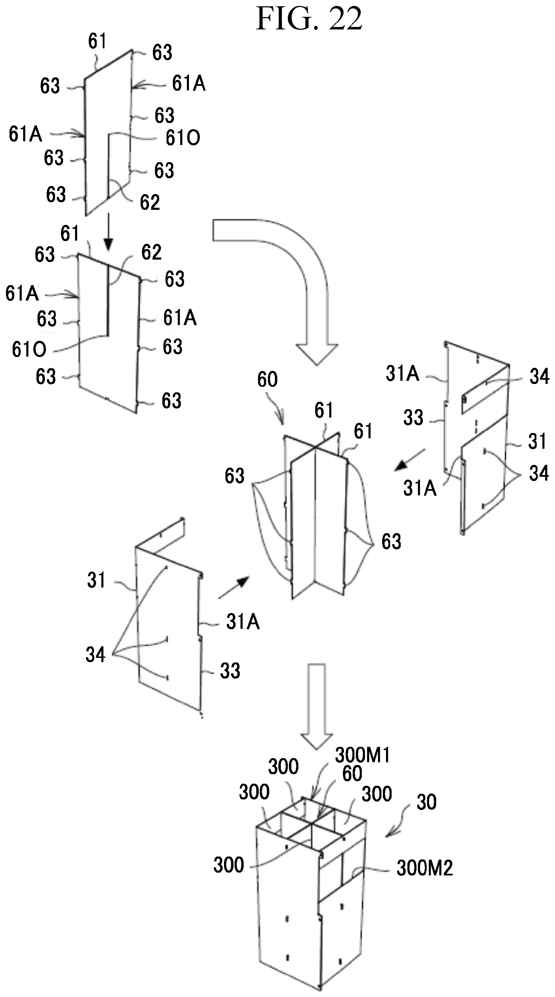

Fig. 22 is an assembly diagram for the partition unit 60 and the light tunnel 30. As shown in the drawing, the partition unit 60 includes two rectangular reflective plates 61, 61. A reflective plate 61 that is any one of the reflective plates 61, 61 is provided with an insertion slit 62 extending to a center 610 of the reflective plate 61 along a central axis of the reflective plate 61. In addition, the insertion slit 62 of the reflective plate 61 that is any one of the two reflective plates 61 is inserted into an insertion slit 62 of the other reflective plate 61; as a result, the partition unit 60 dividing the light tunnel 30 into the four conduits 300 and having an interlocking structure is assembled.

In addition, the light tunnel 30 includes two reflective plates 31, 31 each bent to have a shape of an "L" in plan view. These two reflective plates 31, 31 are fastened together in orientations facing each other; as a result, the hollow light tunnel 30 having a shape of a square as viewed in cross section is assembled. For more information relating to a fastening structure of the reflective plates 31, 31, an edge portion 31A of a reflective plate 31 that is any one of the reflective plates 31, 31 is provided with a bent piece 32, which is bent outwardly to have a shape of an "L," and a contact piece 33, which is in contact with a bent piece 32 of the other reflective plate 31. In addition, the bent piece 32 of the reflective plate 31 and a contact piece 33 of the other reflective plate 31 are firmly fastened together by fastening means such as bolts or screws.

In addition, edge portions 61A of the reflective plates 61, 61 constituting the partition unit 60 are provided with a plurality of insertion pieces 63. On the other hand, surfaces of the two reflective plates 31, 31 of the light tunnel 30 are provided with insertion holes 34 into which the insertion pieces 63 of the partition unit 60 are to be inserted. In addition, the two reflective plates 31, 31 are fastened together in a state in which the partition unit 60 is sandwiched between the two reflective plates 31, 31 such that the insertion pieces 63 of the partition unit 60 are inserted into the insertion holes 34 of the reflective plates 31, 31; as a result, the partition unit 60 and the light tunnel 30 are fixed to each other in an interlocking structure.

As described above, to fix the reflective plates 61 of the partition unit 60 to each other and to fix the partition unit 60 to the light tunnel 30, interlocking structures are used rather than fastening members such as screws or bolts; thus, none of the inner surfaces of the respective conduits 300 of the light tunnel 30 includes a low reflection section caused by fastening members, and it is possible to substantially prevent loss of the first ultraviolet lights L1, the second ultraviolet lights L2, and the third ultraviolet lights L3 at the point in time of multiple reflection.

It should be noted that, in this embodiment, the dichroic mirrors 410 are fixed by adhesives to the respective conduits 300. In this configuration, edge portions of the dichroic mirrors 410 may be provided with flanges, and in an interlocking structure, the flanges may be fixed to the reflective plates 31, 31 of the light tunnel 30 and to the reflective plates 61, 61 of the partition unit 60.

In addition, in this embodiment, as shown in Fig. 18 described above, fixing pieces 70 are fastened to the contact pieces 33 for fastening the reflective plates 31, 31 together, and these fixing pieces 70 are fastened to the outer housing 2; as a result, the light tunnel 30 described above is fixed.

Here, as shown in Fig. 18, similarly to the light source apparatus 1A according to the first embodiment and the light source apparatus 1B accordance to the second embodiment, the irradiation apparatus 1000 includes first cooler units 50-1 configured to cool the first light source units 10-1 and a second cooler unit 50-2 configured to cool the second light source units 10-2. In this embodiment, the first light source units 10-1 are fixed to the first cooler units 50-1, and the second light source units 10-2 are fixed to the second cooler unit 50-2. In addition, the first cooler units 50-1 and the second cooler unit 50-2 are each fixed to the outer housing 2 rather than to the light tunnel 30. Thus, loads of the first cooler units 50-1, the second cooler unit 50-2, the first light source units 10-1, and the second light source units 10-2 are not applied to the light tunnel 30. In this way, even when the reflective plates 31, 31 of the light tunnel 30 and the reflective plates 61, 61 of the partition unit 60 are made of material with low rigidity such as an aluminum plate, it is possible to prevent deflection of, and damage to, the light tunnel 30 and the partition unit 60. In addition, for example, it is not necessary to increase rigidity of the light tunnel 30 by the partition unit 60; thus, it is possible to reduce a thickness of each of the reflective plates 61, 61 of the partition unit 60, and it is possible to substantially prevent a shadow, which is caused by a thickness of each of the reflective plates 61, 61 and occurs on the irradiation area D, affecting illuminance and spectrum.

In this embodiment, water-cooling units are used as the first cooler units 50-1, and an air-cooling unit is used as the second cooler unit 50-2. More specifically, as shown in Fig. 18, the first cooler units 50-1 each include a water-cooling heat sink 501A in which cooling water circulates, an introduction port 501B for introducing the cooling water into the water-cooling heat sink 501A, and a drain port 501C for draining the cooling water from the water-cooling heat sink 501A. To the water-cooling heat sink 501A, some of the first light source units 10-1 are fixed. The water-cooling heat sink 501A is provided with a plurality of supports 501D. Each of the plurality of supports 501D is fixed to a first support plate 80 that is fixed to the side surface of the outer housing 2; thus, the first cooler units 50-1 are fixed to the outer housing 2.

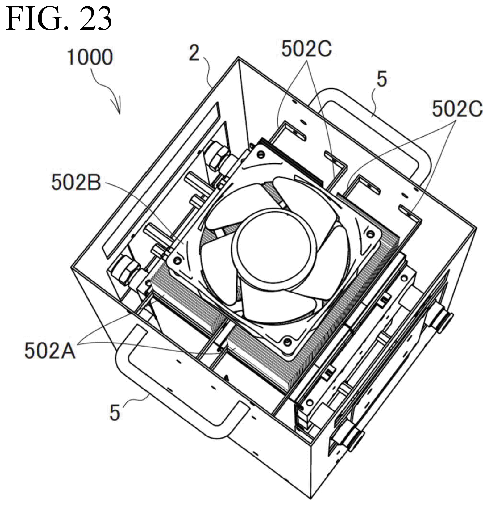

Fig. 23 is a perspective view of the irradiation apparatus 1000 as viewed from above. It should be noted that in the drawing, a second support plate 81 included in the irradiation apparatus 1000 is omitted. As shown in Fig. 18, the second cooler unit 50-2 includes one or more (in this embodiment, two) air-cooling heat sinks 502A, which include a large number of heat dissipating fins, and an axial flow fan 502B for moving cooling air to the air-cooling heat sinks 502A. As shown in Fig. 18 and Fig. 23, in the second cooler unit 50-2, the air-cooling heat sinks 502A are fixed by support rods 502C to the outer housing 2, and as shown in Fig. 18, the axial flow fan 502B is fixed to the second support plate 81 that is fixed to the upper portion 2B of the outer housing 2; as a result, the second cooler unit 50-2 is fixed to the outer housing 2.

As described in the second embodiment, the first light source units 10-1, which include LEDs configured to emit ultraviolet lights with wavelengths shorter than those of the second light source units 10-2, consume more power, and increase heat generation. Furthermore, in the first light source units 10-1 according to this embodiment, which are configured to emit the second ultraviolet lights L2 that are introduced into the respective conduits 300, the number and density of the ultraviolet LEDs are increased and heat generation is significantly increased compared to the first light source unit 10-1 according to the first embodiment and the second embodiment. In contrast to this, in this embodiment, as a cooling method for the first light source units 10-1, a water-cooling method capable of realizing a higher cooling performance compared to an air-cooling method is used; thus, it is possible to sufficiently cool the first light source units 10-1 that increase heat generation, and it is possible to substantially prevent reduction in effectiveness of the first light source units 10-1 caused by the heat generation.

In contrast, as shown in Fig. 20, in this embodiment, the second light source units 10-2 include a plurality of LED board groups 100G, and the plurality of LED board groups 100G are in one-to-one correspondence with the plurality of conduits 300, and into a conduit 300, a second ultraviolet light L2 emitted from the corresponding LED board group 100G is introduced.

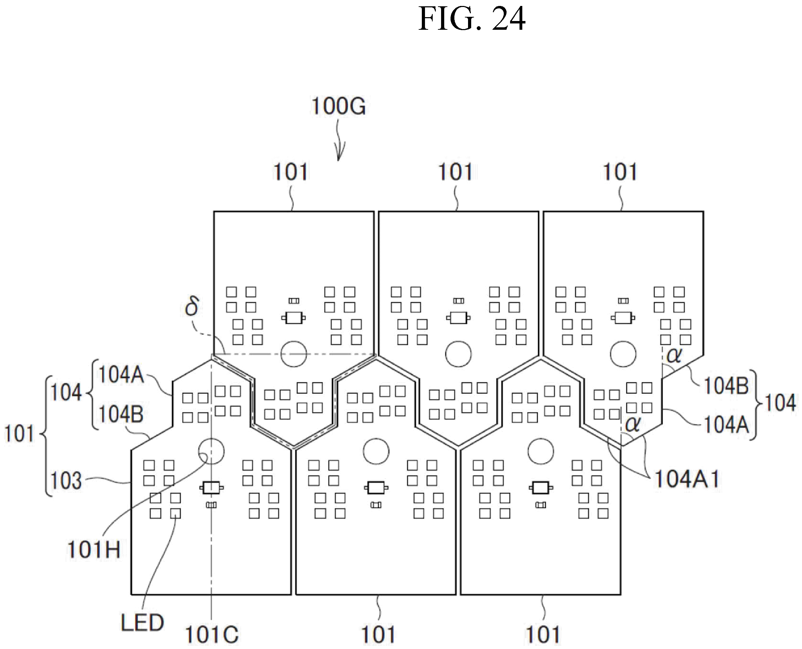

Fig. 24 is a plan view of an LED board group 100G. An LED board group 100G includes a plurality (in this embodiment, six) LED boards 101. A surface of each of the plurality of LED boards 101 is provided with a hole 101H for being fastened, and the hole 101H into which a fastening member such as a screw is inserted is fixed to a base plate 102 (Fig. 20). It should be noted that between the LED boards 101 and the base plate 102, thermally conductive grease is applied or a thermally conductive sheet is sandwiched; as a result, heat generated by the LEDs is conducted to the air-cooling heat sinks. An LED board group 100G is comparable to the LED board 100 according to the first embodiment and the second embodiment, and includes four types of ultraviolet LEDs constituted of third ultraviolet LEDs, fourth ultraviolet LEDs, fifth ultraviolet LEDs, and sixth ultraviolet LEDs similarly to the LED board 100. The arrangement of the ultraviolet LEDs on the LED board 100 may be freely selected.

Shapes in plan view and dimensions of the respective LED boards 101 are each the same (i.e., have congruent shapes), and an LED board 101 according this embodiment includes a rectangular portion 103 and an engaging shape portion 104. The rectangular portion 103 is a portion of the LED board 101 that is rectangular in plan view.

In contrast, the engaging shape portion 104 is a portion that is continuous with a side of the rectangular portion 103. In plan view, a shape of this engaging shape portion 104 is symmetric with respect to a central line 101C of the LED board 101 and is a shape forming a receiving potion δ, which is a space having a shape that corresponds to an outline of the engaging shape portion 104, between the engaging shape portion 104 and an engaging shape portion 104 of another LED board 101 that is adjacent in a lateral direction. It should be noted that in Fig. 24, a shape of the receiving portion δ is shown by a long-dash double-short-dash line.

Since each of the plurality of LED boards 101 includes the rectangular portion 103, it is possible to arrange the plurality of LED boards 101 in the lateral direction substantially without any gap, and it is possible to easily extend a light emitting area of the second light source units 10-2 in the lateral direction. In addition, each receiving portion δ formed by two adjacent LED boards 101 in the lateral direction is engaged with an engaging shape portion 104 of another LED board 101 that is in an upside-down orientation; thus, it is possible to easily extend the light emitting area of the second light source units 10-2 in a vertical direction.

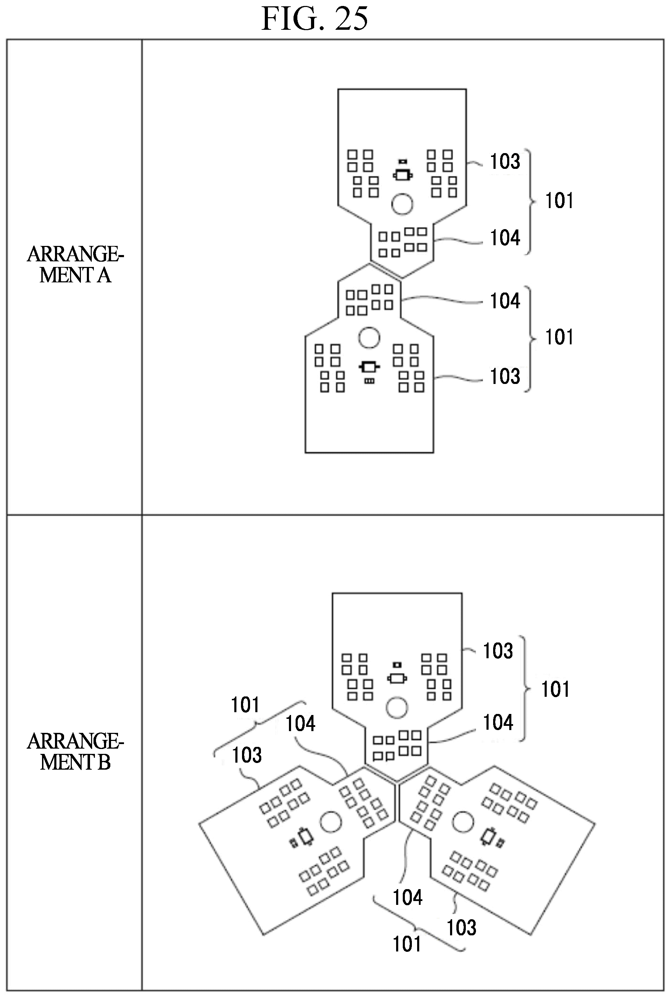

Here, an engaging shape portion 104 according to this embodiment includes a protrusion 104A, and shoulders 104B. In plan view, a shoulder 104B is shaped to have a section, which is disposed between the rectangular portion 103 and the protrusion 104A and is inclined relative to the central line 101C at a predetermined angle α (in this embodiment, α = 30 degrees). Furthermore, in plan view, a shape of a tip portion of the protrusion 104A is a shape of a "V" constituted of two sides 104A1 inclined at the angle α, as in the shoulder 104B. Since each of the plurality of LED boards 101 includes the engaging shape portion 104; thus, it is possible to increase variations in arrangements of the LED boards 101. Specifically, depending on how the engaging shape portions 104 of the plurality of LED boards 101 engage with one another, as shown in an arrangement A in Fig. 25, it is possible to align two LED boards 101, which are vertically inverted to each other, in the vertical direction, or as shown in an arrangement B in Fig. 25, it is possible to arrange multiple LED boards 101 in a star shape, for example.

As described above, the light source apparatus 1C according to this embodiment includes the partition unit 60 dividing the interior of the light tunnel 30 into the plurality of conduits 300. According to this configuration, in individual areas irradiated by each of the plurality of conduits 300, illuminance and spectrum distribution are uniform, and these areas are adjacent to one another to form the irradiation area D; thus, it is possible to extend an area of the irradiation area D and to increase illuminance compared to the light source apparatus 1B according to the second embodiment, and to maintain uniformity of spectrum distribution. The irradiation apparatus 1000 including the light source apparatus 1C achieves approximately three times the illuminance caused by the light source apparatus 1B (approximately 150 mW/cm²).

In addition to this, since the interior of the light tunnel 30 is divided into the plurality of conduits 300, a cross-sectional area of each of the plurality of conduits 300 is reduced, and the number of multiple reflections of each of the first ultraviolet light L1, the second ultraviolet light L2, and the third ultraviolet light L3 within the interior of each of the plurality of conduits 300 increases. Thus, it is possible to reduce an overall length of the light tunnel 30 while maintaining uniformity of illuminance and spectrum distribution in the irradiation area D.

In the light source apparatus 1C according to this embodiment, the partition unit 60 includes the plurality of reflective plates 61, and the plurality of reflective plates 61 are fixed to each other in an interlocking structure. According to this configuration, none of the inner surfaces of the respective conduits 300 includes a low reflection section caused by fastening members, and it is possible to substantially prevent loss of the first ultraviolet lights L1, the second ultraviolet lights L2, and the third ultraviolet lights L3 at a point in time of multiple reflection.

The irradiation apparatus 1000 according to this embodiment includes the light source apparatus 1C, the first cooler units 50-1 configured to cool the first light source units 10-1, the second cooler unit 50-2 configured to cool the second light source units 10-2, and the outer housing 2 accommodating the light source apparatus 1C, wherein the first cooler units 50-1 and the second cooler unit 50-2 are fixed to the outer housing 2. According to this configuration, even when the reflective plates 31, 31 of the light tunnel 30 and the reflective plates 61, 61 of the partition unit 60 are made of material with low rigidity such as an aluminum plate, it is possible to prevent deflection of, and damage to, the light tunnel 30 and the partition unit 60. In addition, for example, it is not necessary to increase rigidity of the light tunnel 30 by the partition unit 60; thus, it is possible to reduce a thickness of each of the reflective plates 61, 61 of the partition unit 60, and it is possible to substantially prevent effects of a shadow caused by a thickness of each of the reflective plates 61, 61 and occurs on the irradiation area D, on illuminance and spectrum.

It should be noted that in the third embodiment, the irradiation apparatus 1000 may include the plurality of light source apparatuses 1A, the plurality of light source apparatuses 1B, or a plurality of light source apparatuses 1C, and the outer housing 2 may accommodate the plurality of light source apparatuses 1A, the plurality of light source apparatuses 1B, or the plurality of light source apparatuses 1C in a state in which light tunnels 30 are connected to, and are in contact with, one another so as to extend an area of the irradiation area D.

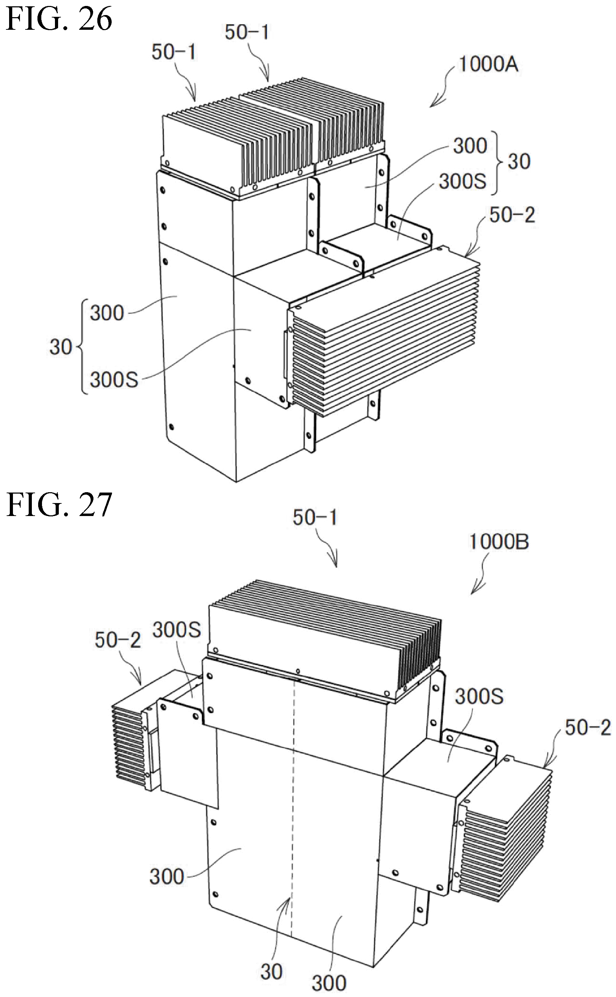

In addition, the irradiation apparatus 1000 may include elements of the plurality of light source apparatuses 1A according to the first embodiment, in place of the light source apparatus 1B according to the second embodiment. In this case, for example, as shown in Fig. 26, an irradiation apparatus 1000A may be configured in which a plurality of (in an example shown in the drawing, two) light source apparatuses 1A are arranged in the lateral direction and light tunnels 30 of the respective light source apparatuses 1A are connected to, and are in contact with, each other, for example. Alternatively, for example, as shown in Fig. 27, an irradiation apparatus 1000B may be configured in which a pair of light source apparatuses 1A are disposed to face each other and the light tunnels 30 of the respective light source apparatuses 1A are connected to, and are in contact with, each other. In addition, each of the irradiation apparatus 1000A and the irradiation apparatus 1000B may include the outer housing 2, and each of the light source apparatuses 1A may be accommodated in the corresponding outer housing 2, and a first cooler unit 50-1 and second cooler units 50-2 may be fixed to the outer housing 2.

### 4. Modifications

Modified modes that may be applied to each of the embodiments described above are described below. Two or more modifications freely selected from the following modifications may be combined as long as no conflict arises from such a combination.

By the light source controller controlling each of the different types of ultraviolet LEDs provided in the first light source unit 10-1 and the second light source unit 10-2, a relative intensity of the spectrum of the third ultraviolet light L3 may be dynamically changed.

By a plurality of light source apparatuses 1A or a plurality of light source apparatuses 1B being provided, a light source system may be configured to irradiate a larger irradiation area D. In addition, by increasing a cross-sectional size of the light tunnel 30 of the light source apparatus 1A or of the light source apparatus 1B, the irradiation area D may be increased.

In each of the first light source unit 10-1 and the second light source unit 10-2, by more ultraviolet LEDs being provided on the LED board 100 in high density, a configuration in which higher illuminance can be obtained may be realized.

The ultraviolet LEDs provided in each of the first light source unit 10-1 and the second light source unit 10-2 may be of a bare-chip type rather than of a packaged type. In this case, a plate on which bare-chip type ultraviolet LEDs are provided may be used as the LED board 100.

A wavelength range of the semiconductor light sources included in each of the first light source unit 10-1 and the second light source unit 10-2 is not limited to a range of 325 nm to 405 nm described in the first embodiment and the second embodiment. In other words, the wavelength range of the semiconductor light sources may be a UV-C range less than 300 nm, a visible light range, or an infrared range.

### Description of Reference Signs

1A... light source apparatus, 1B... light source apparatus, 1C... light source apparatus, 10-1... first light source unit, 2... outer housing, 10-2... second light source unit, 50-1... first cooler unit, 50-2... second cooler unit, 30... light tunnel, 30A... inner surface, 40... mixing optical system, 60... partition unit, 61... reflective plate, 100... LED board, 110... mounting board, 110R... central area, 120... reflective plate, 300... conduit, 300M1... first inlet, 300M2... second inlet, 300Q... outlet, 400... beam splitter, 410... dichroic mirror, 1000... irradiation apparatus, D... irradiation area, K1... first optical axis, K2... second optical axis, L1... first ultraviolet light, L2... second ultraviolet light, L3... third ultraviolet light.

## Claims

1. A light source apparatus comprising:
a first light source unit including one or more types of semiconductor light sources and configured to emit a first ultraviolet light;
a second light source unit including one or more types of semiconductor light sources and configured to emit a second ultraviolet light differing in at least one of central wavelength and spectrum from the first ultraviolet light;
a light tunnel configured to guide each of the first ultraviolet light and the second ultraviolet light; and
a mixing optical system provided within the light tunnel and configured to mix the first ultraviolet light and the second ultraviolet light to obtain a third ultraviolet light,
wherein an inner surface of the light tunnel is a reflective surface configured to reflect the first ultraviolet light, the second ultraviolet light, and the third ultraviolet light, and
wherein the light tunnel is configured to emit the third ultraviolet light obtained through mixture by the mixing optical system.

2. The light source apparatus according to claim 1,
wherein the first light source unit is configured to emit the first ultraviolet light within a range of radiation angles at which multiple reflection occurs on the inner surface of the light tunnel, and
wherein the second light source unit is configured to emit the second ultraviolet light within a range of radiation angles at which multiple reflection occurs on the inner surface of the light tunnel.

3. The light source apparatus according to claim 1,
wherein the light tunnel includes a hollow conduit extending linearly,
wherein an end portion of the conduit is provided with an opening that is an outlet configured to emit the third ultraviolet light,
wherein an opposite end portion of the conduit is provided with an opening that is a first inlet configured to let in a light among the first ultraviolet light and the second ultraviolet light,
wherein a side surface of the conduit is provided with an opening that is a second inlet configured to let in another light among the first ultraviolet light and the second ultraviolet light, and
wherein among the first light source unit and the second light source unit, a light source unit configured to emit an ultraviolet light with a shorter wavelength is provided at the second inlet.

4. The light source apparatus according to claim 1, further comprising:
a partition unit dividing an interior of the light tunnel into a plurality of conduits.

5. A light source apparatus comprising:
a first light source unit including one or more types of semiconductor light sources and configured to emit a first ultraviolet light;
a light tunnel; and
a partition unit dividing an interior of the light tunnel into a plurality of conduits,
for a conduit that is any one of the plurality of conduits, the light source apparatus further comprising:
a second light source unit including one or more types of semiconductor light sources and configured to emit a second ultraviolet light with a wavelength shorter than that of the first ultraviolet light; and
a mixing optical system provided within the conduit and configured to mix the first ultraviolet light and the second ultraviolet light to obtain a third ultraviolet light,
wherein an inner surface of the light tunnel is a reflective surface configured to reflect the first ultraviolet light, the second ultraviolet light, and the third ultraviolet light,
wherein the light tunnel is configured to emit the third ultraviolet light obtained through mixture by the mixing optical system, and
wherein a side surface of the light tunnel is provided with an opening that is a second inlet for the conduit that is any one of the plurality of conduits, the second inlet for the conduit that is any one of the plurality of conduits being provided with the second light source unit corresponding to the conduit.

6. The light source apparatus according to claim 4 or 5,
wherein the partition unit includes a plurality of reflective plates, and
wherein the plurality of reflective plates are fixed to each other in an interlocking structure.

7. The light source apparatus according to claim 3, wherein among the first light source unit and the second light source unit, the light source unit provided at the second inlet includes a reflector configured to reflect an ultraviolet light emitted by another light source unit.

8. The light source apparatus according to any one of claims 1 to 4, wherein the mixing optical system includes a dichroic mirror.

9. An irradiation apparatus comprising:
a light source apparatus according to any one of claims 1 to 4;
a first cooler unit configured to cool the first light source unit;
a second cooler unit configured to cool the second light source unit; and
an outer housing accommodating the light source apparatus,
wherein the first cooler unit and the second cooler unit are fixed to the outer housing.

10. An irradiation apparatus comprising:
a plurality of light source apparatuses each of which is a light source apparatus according to any one of claims 1 to 4; and
an outer housing accommodating the plurality of light source apparatuses including light tunnels that are coupled to each other.
